# EUROPÄISCHE PATENTSCHRIFT

(11) **EP 3 347 303 B1**
(45) Veröffentlichungstag und Bekanntmachung des Hinweises auf die Patenterteilung: **28.07.2021**
(21) Anmeldenummer: 16760468.5
(22) Anmeldetag: 02.09.2016
(51) Int. Cl.: B81C 1/00, G03F 7/00, H01L 31/0224, H01L 51/00, H01L 51/44, G02F 1/1343

(54) **VERFAHREN ZUR HERSTELLUNG VON STRUKTURIERTEN OBERFLÄCHEN**
METHOD FOR PRODUCING STRUCTURED SURFACES
PROCÉDÉ DE PRODUCTION DE SURFACES STRUCTURÉES

(30) Priorität: 07.09.2015 DE 102015115004
(43) Veröffentlichungstag der Anmeldung: 18.07.2018
(73) Patentinhaber: Leibniz-Institut für Neue Materialien gemeinnützige GmbH, 66123 Saarbrücken (DE)
(72) Erfinder: MAURER, Johannes H.M., 71034 Böblingen (DE); KRAUS, Tobias, 66111 Saarbrücken (DE); GONZÁLEZ-GARCÍA, Lola, 66123 Saarbrücken (DE); REISER, Beate, 67655 Kaiserslautern (DE); KANELIDIS, Ioannis, 66111 Saarbrücken (DE); DE OLIVEIRA, Peter, William, 66123 Saarbrücken (DE); KAMPKA, Jenny, 66740 Saarlouis-Picard (DE); MOH, Karsten, 66440 Blieskastel-Brenschelbach (DE)
(74) Vertreter: Patentanwälte Gierlich & Pischitzis Partnerschaft mbB
(86) Internationale Anmeldenummer: PCT/EP2016/070686
(87) Internationale Veröffentlichungsnummer: WO 2017/042094

(56) Entgegenhaltungen:
- EP-A1- 1 323 793
- EP-A2- 1 947 701
- GONZALEZ-GARCIA LOLA ET AL: "Ultrathin Gold Nanowires for Transparent Electronics: Breaking Barriers", PROCEDIA ENGINEERING, Bd. 141, 28. Juni 2015 (2015-06-28), Seiten 152-156, XP029456933, ISSN: 1877-7058, DOI: 10.1016/J.PROENG.2015.08.1120

## Beschreibung

### Gebiet der Erfindung

Die Erfindung betrifft ein Verfahren zur Herstellung von strukturierten, insbesondere leitfähigen Oberflächen, sowie solche Strukturen auf Substraten und ihre Verwendung.

### Stand der Technik

Leitfähige transparente Elektroden (transparent conductive electrodes TCE) sind wichtige Bestandteile moderner Geräte, wie Touch-screens, Solarzellen, etc.

Gerade bei transparenten Elektroden müssen die aufgebrachten Strukturen besonders fein und gleichmäßig strukturiert sein.

Zur Herstellung sind Prozesse bekannt, welche auf Lithografie oder Transferdruck basieren. Häufig beinhalten diese Prozesse Behandlungen im Vakuum, insbesondere um metallische Schichten aufzubringen.

Aus US2003/0168639 A1 ist bekannt, dass Nanopartikel durch einen entsprechenden Stempel zu Strukturen geformt werden können. Um die Strukturen leitfähig zu erhalten ist ein hoher Gehalt an Partikeln notwendig. Daher sind die erhaltenen Strukturen nicht transparent. Um leitfähige Strukturen zu erhalten, ist außerdem eine thermische Behandlung notwendig. EP 1 947 701 A2 beschreibt, dass eine Walze oder ein Stempel mit Aussparungen eines vorbestimmten Musters verwendet werden kann, um eine Metallnanodraht-Dispersionsschicht aufzubringen und so eine gemusterte leitfähige Schicht zu drucken.

### Aufgabe

Aufgabe der Erfindung ist es, ein Verfahren anzugeben, das die Herstellung von metallischen Strukturen auf einfache Weise ermöglicht, insbesondere von leitfähigen Strukturen. Das Verfahren soll auch die Herstellung von transparenten Strukturen ermöglichen.

### Lösung

Diese Aufgabe wird durch die Erfindungen mit den Merkmalen der unabhängigen Ansprüche gelöst. Vorteilhafte Weiterbildungen der Erfindungen sind in den Unteransprüchen gekennzeichnet.

Die Aufgabe wird gelöst durch ein Verfahren zur Herstellung von metallischen Strukturen aus Bündeln von Nanodrähten, wobei eine Zusammensetzung umfassend metallische Nanodrähte und mindestens ein Lösungsmittel bereitgestellt wird. Diese wird auf einem Substrat strukturiert und zwar durch Kontaktieren einer Strukturvorlage mit der Zusammensetzung vor oder nach der Kontaktierung der Zusammensetzung mit dem Substrat.

Danach wird mindestens teilweise das Lösungsmittel mit auf das Substrat aufgebrachter Strukturvorlage entfernt. Dadurch kommt es zur verstärkten Anlagerung der Nanodrähte auf der Oberfläche entsprechend der Strukturierung. Dadurch werden Bündel parallel ausgerichteter Nanodrähte auf der Oberfläche ausgebildet.

Bevorzugt ist eine vollständige Entfernung des mindestens einen Lösungsmittels.

Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.

Entsprechend der Erfindung erfolgt die Strukturierung durch Kontaktieren einer Strukturvorlage mit der Zusammensetzung vor oder nach der Kontaktierung der Zusammensetzung mit einer Oberfläche.

In einer bevorzugten Ausführungsform der Erfindung wird die Zusammensetzung auf einem Substrat aufgetragen und danach eine Strukturvorlage aufgebracht, unter teilweiser Verdrängung der Zusammensetzung. Durch die teilweise Verdrängung kommt es zum Kontakt zwischen der Strukturvorlage und der Oberfläche des Substrats. Dieses Verfahren hat den Vorteil, dass durch die gezielte Verdrängung der Zusammensetzung auf einfache Weise eine Strukturierung erreicht werden kann. Solche Strukturvorlagen können auf einfache Weise hergestellt werden.

In einer ebenfalls bevorzugten Ausführungsform der Erfindung wird die Zusammensetzung auf eine Strukturvorlage aufgebracht und die so behandelte Strukturvorlage auf die Oberfläche aufgebracht. Die Zusammensetzung kann sich beispielsweise in tieferen Strukturen der Strukturvorlage befinden.

Im nächsten Schritt wird das Lösungsmittel mindestens teilweise entfernt. Dies kann auf viele Weisen geschehen. Beispielsweise durch Verdunsten des Lösungsmittels, wobei das Verdunsten durch Erwärmen unterstützt werden kann. Aufgrund der üblicherweise geringen Mengen kann die Verdunstung auch bei aufgebrachter Strukturvorlage stattfinden. Wie stark erwärmt wird ist von den verwendeten Materialien und Lösungsmitteln abhängig. Beispielsweise kann es sich um eine Erwärmung auf bis zu 100 °C handeln.

Erfindungsgemäß findet das mindestens teileweise Entfernen des Lösungsmittels mit auf die Oberfläche aufgebrachter Strukturvorlage statt.

Die Zusammensetzung umfasst Nanodrähte. Im Sinne der Erfindung werden darunter im Allgemeinen längliche Körper verstanden mit einem Aspektverhältnis von über 100, im Gegensatz zu sphärischen Nanopartikeln oder Nanostäbchen. Ein solcher Nanodraht lässt sich beispielsweise anhand von zwei Parametern beschreiben. Zum einen der mittlere Durchmesser des Drahts und zum anderen die Länge des Drahts. Nanodrähte zeichnen sich insbesondere dadurch aus, dass sie einen Durchmesser von unter 100 nm, bevorzugt unter 50 nm, bevorzugt unter 20 nm, besonders bevorzugt unter 10 nm aufweisen, insbesondere unter 5 nm. Ihre Länge liegt dabei über 300 nm, bevorzugt über 500 nm, besonders bevorzugt über 1 µm. Die Dimensionen können mittels TEM ermittelt werden. Unter der Länge wird dabei die Länge verstanden, die mindestens 50 Gew.-% der in der Zusammensetzung enthaltenen Nanostäbe aufweisen, insbesondere mindestens 60 Gew.-%, ganz besonders mindestens 80 Gew.-%, insbesondere 100 Gew.-%. Die Nanodrähte liegen in TEM auf der längeren Seite. Die bestimmten Durchmesser stellen daher einen Durchschnitt der Durchmesser von Nanodrähten unterschiedlicher Orientierung dar. In der Zusammensetzung können auch Agglomerate von Nanodrähten auftreten. Die Angaben beziehen sich immer auf einen Nanodraht.

In einer Ausführungsform der Erfindung umfasst die Zusammensetzung Nanodrähte, welche einen mittleren Durchmesser von unter 15 nm, bevorzugt unter 10 nm, insbesondere unter 5 nm aufweisen. Der Durchmesser kann auch bei unter 3 nm, bevorzugt unter 2 nm liegen. Besonders bevorzugte Bereiche liegen zwischen 0,5 nm und 5 nm, insbesondere 0,5 nm und 3 nm, bzw. 0,5 nm bis 2 nm. Die Länge der Nanodrähte liegt dabei bei über 1 µm, bevorzugt über 1,5 µm. Die Länge kann davon unabhängig bei bis zu 15 µm, bevorzugt bis zu 10 µm liegen. Die Länge kann beispielsweise bei 1 µm bis 15 µm liegen, insbesondere bei 2 bis 15 µm.

Die Nanodrähte weisen bevorzugt ein Aspektverhältnis von Länge zu Durchmesser von über 500:1 auf, insbesondere über 1000:1, ganz besonders über 1500:1 oder über 2000:1.

Bevorzugt erfüllen mindestens 50 Gew.-%, bevorzugt mindestens 80 Gew.-%, insbesondere 100 Gew.-%, der Nanodrähte der Zusammensetzung eine der vorstehend angegebenen Größenangaben.

Durch den geringen Durchmesser der Nanodrähte weisen diese eine hohe Biegsamkeit auf. Sie können sich daher an Strukturen anpassen ohne zu brechen. Auch neigen sie aufgrund ihrer besonders großen Oberfläche zur Bildung von Bündeln. Dies wird durch die Biegsamkeit noch begünstigt.

Bei der Entfernung des Lösungsmittels führt dieses hohe Aspektverhältnis dazu, dass sich die Drähte zu wenigen Bündeln aneinanderlagern. Durch ihre Biegsamkeit können sie dabei auch komplizierteren Strukturen der Strukturvorlage folgen. Dadurch ist die Herstellung von gebogenen oder sich kreuzenden Strukturen wie Gittern problemlos möglich. Da sich die Nanodrähte versetzt anlagern wird eine kontinuierliche Struktur gebildet. Aufgrund der parallelen Ausrichtung weist ein solches Bündel deutlich weniger Grenzflächen zwischen metallischen oder halbmetallischen Phasen auf. Dadurch ist die Leitfähigkeit längs des Bündels besser als bei vergleichbarer Anordnung von Nanopartikeln. Es ist ein perkolierendes Netzwerk möglich. Die Bündel liegen dabei parallel zur Oberfläche und folgen in Längsrichtung den Vertiefungen der Strukturvorlage.

Die parallele Ausrichtung ermöglicht auch eine anisotrope Leitfähigkeit zu erhalten.

Durch das hohe Aspektverhältnis wird die Anlagerung der Nanodrähte zu Bündeln begünstigt. Außerdem reduziert sich durch das hohe Aspektverhältnis die Zahl der Kontaktstellen entlang eines Leitungsweges bestimmter Distanz im Vergleich zu sphärischen Nanopartikeln.

Durch die Bildung von Bündeln ist die gebildete Struktur bevorzugt dünner als die durch die Vertiefung in der Strukturvorlage vorgegebenen Abstand.

Zur Herstellung der Nanodrähte kommen alle dem Fachmann bekannten Verfahren in Betracht. Dies ist beispielsweise die Reduktion von entsprechenden Salzlösungen. Für solche Verfahren sind Bedingungen bekannt unter denen Nanodrähte erhalten werden. Ein Beispiel für ein solches Verfahren ist in Feng et al., Simple and Rapid Synthesis of Ultrathin Gold Nanowires, their Selfassembly and Application in Surface-enhanced Raman Scattering. Chem. Commun. 2009, 1984-1986 beschrieben.

In der Erfindung handelt es sich um metallische Nanodrähte. Es kann sich um metallische Nanodrähte handeln, welche ein Metall, Mischungen aus zwei oder mehr Metallen oder eine Legierung aus zwei oder mehr Metallen umfassen, z. B. FePt. Bevorzugt sind die Metalle ausgewählt aus den Metallen der IUPAC-Gruppen 1 bis 16, sowie der Lanthanoiden, bevorzugt aus den Metallen der Gruppen 4 bis 16, insbesondere Au, Ag, Cu, Pt, Pd, Ni, Ru, In, Rh, Al, Pb, Bi, Te. Die Nanodrähte können auch leitfähige oder halbleitfähige Oxide umfassen. Beispiele für solche Oxide, welche auch dotiert sein können, sind Indium-Zinn-Oxid (ITO) oder Antimon-Zinn-Oxid (ATO). Es können auch Halbleiter der Gruppen II-VI, III-V oder IV oder Legierung solcher Halbleiter sein. Beispiele dafür sind CdS, CdSe, CdTe, InP, InAs, ZnS, ZnSe, ZnTe, HgTe, GaN, GaP, GaAs, GaSb, InSb, Si, Ge, AlAs, PbSe oder PbTe. Außerhalb der Erfindung können es auch nichtmetallische Nanodrähte sein, beispielsweise aus Oxiden, Sulfiden, Seleniden der vorstehend genannten Metalle. Beispiele dafür sind Cu₂S, Bi₂S₃, Sb₂S₃, SmO₃, PbS.

Die Konzentration der Nanodrähte in der Zusammensetzung liegt bevorzugt bei unter 30 mg/ml, insbesondere unter 15 mg/ml, bevorzugt unter 10 mg/ml. Durch die Konzentration kann die Dicke der erhaltenen Strukturen gesteuert werden. Bevorzugt liegt die Konzentration bei über 0,1 mg/ml, insbesondere bei über 0,5 mg/ml, beziehungsweise bei über 1 mg/ml, sowie in einem Bereich zwischen den vorstehend angegebenen Grenzwerten.

Die Zusammensetzung kann außerdem mindestens einen Stabilisator erhalten. Darunter werden Verbindungen verstanden, welche eine Aggregation der Nanodrähte bei der in der Zusammensetzung vorliegenden Konzentration an Nanodrähten verhindern. Dies sind üblicherweise Verbindungen, welche sich an die Oberfläche der Nanodrähte anlagern. Häufig sind dies organische Verbindungen mit mindestens einer funktionalen Gruppe ausgewählt aus Hydroxylgruppen, Sulfidgruppen, Ethergruppen, Carboxylatgruppen, Estergruppen oder Aminogruppen. Diese Verbindungen können auch die Wahl des Lösungsmittels beeinflussen. Für unpolare Lösungsmittel können dies beispielsweise Alkylamine, Alkohole, Carbonsäuren, Thiole sein mit aliphatischen Resten mit 4 bis 30 Kohlenstoffatomen.

Als Lösungsmittel eignen sich dem Fachmann bekannte Lösungsmittel für Nanodrähte. Bevorzugt sind Lösungsmittel, welche einen Siedepunkt von unter 150 °C aufweisen. Es können polare oder unpolare Lösungsmittel sein. Beispiele für polare Lösungsmittel sind deionisiertes H₂O, Methanol, Ethanol, Isopropanol, n-Propanol oder Butanol, Ketone wie Aceton, Ether wie Diethylether, Methyl-tert.-Butylether, Tetrahydrofuran, Ester wie Ethylacetat, Halogenierte Lösungsmittel wie Dichlormethan, Chloroform. Beispiele für unpolare Lösungsmittel sind aliphatische oder cycloaliphatische Kohlenwasserstoffe wie n-Pentan, Isopentan, n-Butan, n-Hexan, Isohexan oder Cyclohexan, Methylcyclohexan, Benzol, Toluol, Naphthalin möglich.

Das Substrat kann jedes für diesen Zweck geeignete Material sein. Beispiele für geeignete Materialien sind Metalle oder Metalllegierungen, Glas, Keramik, einschließlich Oxidkeramik, Glaskeramik oder Kunststoffe, sowie Papier und andere zellulosehaltige Materialien. Selbstverständlich sind auch Substrate verwendbar, die eine Oberflächenschicht aus den vorstehend genannten Materialien aufweisen. Bei der Oberflächenschicht kann es sich z.B. um eine Metallisierung, eine Emaillierung, eine Glas- oder Keramikschicht oder eine Lackierung handeln.

Beispiele für Metalle oder Metalllegierungen sind Stahl, einschließlich Edelstahl, Chrom, Kupfer, Titan, Zinn, Zink, Messing und Aluminium. Beispiele für Glas sind Natronkalkglas, Borosilikatglas, Bleikristall und Kieselglas. Es kann sich z.B. um Flachglas, Hohlglas wie Behälterglas, oder um Laborgeräteglas handeln. Bei der Keramik handelt es sich z.B. um eine Keramik auf Basis der Oxide SiO₂, Al₂O₃, ZrO₂ oder MgO oder der entsprechenden Mischoxide. Beispiele für den Kunststoff, der, wie auch das Metall, als Folie vorliegen kann, sind Polyethylen (PET), z.B. HDPE oder LDPE, Polypropylen, Polyisobutylen, Polystyrol (PS), Polyvinylchlorid (PVC), Polyvinylidenchlorid, Polyvinylbutyral, Polytetrafluorethylen, Polychlortrifluorethylen, Polyacrylate, Polymethacrylate wie Polymethylmethacrylat (PMMA), Polyamid, Polyethylenterephthalat, Polycarbonat, regenerierte Cellulose, Cellulosenitrat, Celluloseacetat, Cellulosetriacetat (TAC), Celluloseacetatbutyrat oder Kautschuk-Hydrochlorid. Eine lackierte Oberfläche kann aus üblichen Grundanstrichen oder Lacken gebildet sein. In einer bevorzugten Ausführungsform sind die Substrate Folien, insbesondere Polyethylenterephthalatfolien oder Polyimidfolien.

Zum Aufbringen der Zusammensetzung können übliche Verfahren verwendet werden, beispielsweise Tauchen, Rollen, Rakeln, Fluten, Ziehen, Spritzen, Schleudern oder Aufstreichen. Auch können weitere Hilfsstoffe, wie Benetzungshilfsmittel enthalten sein.

Beispielsweise kann das Auftragen der Zusammensetzung über einen Rahmen, welcher auf das Substrat gelegt wird und in den dann gebildeten durch den Rahmen begrenzten Raum die Zusammensetzung gegeben wird. Der Rahmen kann aus einem elastischen Material bestehen. Der Rahmen kann beliebige Formen aufweisen.

In einem weiteren Schritt einer bevorzugten Ausführungsform der Erfindung wird auf die aufgetragene Zusammensetzung eine Strukturvorlage unter teilweiser Verdrängung der Zusammensetzung aufgebracht. Bei der Strukturvorlage handelt es sich um eine beliebig geformte Vorlage, welche durch in Kontakt treten mit der Oberfläche des Substrats an diesen Stellen die Zusammensetzung verdrängt. Dabei muss die Zusammensetzung auf der Oberfläche des Substrats so viskos oder flüssig sein, dass es zu einer Verdrängung kommen kann.

Die Strukturvorlage kann beispielsweise ein Stempel sein. Die Strukturvorlage kann aus beliebigen Materialien geformt sein. Mögliche Materialien für die Strukturvorlage sind dem Fachmann aus dem Bereich der Mikrostrukturstempel bekannt. Sie können beispielsweise auch mit lithographischen Verfahren erhalten werden. Beispiele sind Metalle, wie Nickel, Halbmetalle wie Silizium oder Photolacke. Es können auch Silikone wie PDMS (Polydimethylsiloxan) verwendet werden.

Die Strukturvorlage weist bevorzugt Vertiefungen und Vorsprünge auf, welche Linien oder einem Gitter entsprechen. Die einzelnen Vorsprünge können quadratische, rechteckige, runde und/oder ovale Grundflächen aufweisen. Bevorzugt sind sie regelmäßig angeordnet, so dass die dazwischen liegenden Vertiefungen zur Bildung einer Gitterstruktur führen.

Die minimale Breite der Vertiefungen der Strukturvorlage liegt bevorzugt bei unter 2 µm.

Es kann erforderlich sein, die Oberfläche der Strukturvorlage zu behandeln, beispielsweise durch Behandlung mit fluorierten Silanen.

Die Oberfläche der Strukturvorlage kann auch durch andere Behandlungen, wie Plasmabehandlung, modifiziert werden. Dadurch kann die Strukturvorlage an die Zusammensetzung angepasst werden.

Es kann notwendig sein, die Ausbildung der Strukturvorlage an die Dicke der Schicht der Zusammensetzung anzupassen, beispielsweise um genügend Raum für die verdrängte Vorläuferverbindung sowie eventuell eingeschlossene Luft bereitzustellen. Ebenso kann dies durch die Dicke der Strukturvorlage, beziehungsweise durch die Tiefe der auf ihrer Oberfläche vorhandenen Vertiefungen, beeinflusst werden.

Die Strukturvorlage stellt bezogen auf die durch sie kontaktierte Fläche ein Negativ der gewünschten Struktur dar.

Es ist auch möglich, dass die Zusammensetzung zuerst auf die Strukturvorlage aufgebracht wird und beides zusammen auf das Substrat aufgebracht wird.

Nach dem mindestens teilweise Entfernen des Lösungsmittels wird die Strukturvorlage bevorzugt entfernt.

In einer weiteren Ausführungsform der Erfindung wird das Substrat nach Ausbildung der Struktur und ggf. Entfernung des Lösungsmittels weiter behandelt. Das beschichtete Substrat kann getrocknet werden, beispielsweise durch Erwärmen in einem Ofen, Druckluft und/oder durch Trocknen bei Raumtemperatur.

Es können auch noch weitere Schichten, beispielsweise zum Schutz der beschichteten Oberfläche vor Oxidation und Wasser oder vor UV-Strahlung aufgebracht werden.

In einer bevorzugten Ausführungsform wird nach der Strukturierung, insbesondere nach Entfernung der Strukturvorlage eine Behandlung zur mindestens teilweisen Entfernung von organischen Substanzen durchgeführt. Dies kann beispielsweise eine Temperaturbehandlung bei über 200 °C oder über 400 °C sein. Es kann auch eine Plasmabehandlung sein. Durch die mindestens teilweise Entfernung der organischen Bestandteile wird die eventuell vorhandene organische Hülle um die Nanodrähte verringert, bzw. entfernt. Dadurch wird die Übertragung von Elektronen zwischen den Nanodrähten erleichtert. So kann die Leitfähigkeit der erhaltenen Struktur stark verbessert werden. Bevorzugt ist eine Plasmabehandlung.

Mögliche Wege zum Erhalt von Plasma unter Vakuumbedingungen sind in der Literatur häufig beschrieben worden. Die elektrische Energie kann durch induktive oder kapazitive Mittel verknüpft werden. Sie kann Gleichstrom oder Wechselstrom sein; die Frequenz des Wechselstroms kann von einigen kHz bis in den MHz-Bereich reichen. Eine Energiezufuhr im Mikrowellenbereich (GHz) ist auch möglich.

Als primäre Plasmagase können beispielsweise He, Argon, Xenon, N₂, O₂, H₂, Dampf oder Luft, und ebenso Gemische aus diesen Verbindungen verwendet werden. Bevorzugt ist ein Plasma aus Wasserstoff und Argon, beispielweise 1 bis 20 Vol.-% Wasserstoff in Argon, insbesondere H₂/Ar 5%/95%.

Eine Plasmabehandlung kann dabei bei Temperaturen von unter 50 °C, insbesondere bei Raumtemperatur, durchgeführt werden. Dadurch ist mit dem erfindungsgemäßen Verfahren die Herstellung von leitfähigen Strukturen ohne einen Schritt bei Temperaturen von über 100 °C möglich, insbesondere von über 60 °C. Es ist auch möglich, dass das gesamte Verfahren bei Raumtemperatur durchgeführt wird.

Auch sind keine Zwischenschritte zur Strukturierung notwendig und auch auf eine chemische Weiterbehandlung kann verzichtet werden.

Es kann erforderlich sein die Oberfläche des Substrats einer Vorbehandlung zu unterziehen. In einer bevorzugten Weiterbildung der Erfindung umfasst die Vorbehandlung eine Plasmabehandlung, Koronabehandlung, Flammenbehandlung und/oder das Auftragen und Härten einer organisch-anorganischen Beschichtung. Eine Plasmabehandlung, Koronabehandlung und/oder Flammenbehandlung kommt insbesondere bei Foliensubstraten, insbesondere bei Kunststofffolien in Betracht.

Im Folgenden wird ein nicht zur Erfindung gehörendes Verfahren beschrieben welches das Auftragen der Zusammensetzung vor oder nach der Strukturierung auf eine inerte Oberfläche umfasst.

Dabei handelt es sich bevorzugt um eine Oberfläche umfassend mindestens eine fluorhaltige Verbindung.

Dies kann beispielsweise eine Oberfläche sein, welche mit einer Zusammensetzung umfassend mindestens ein hydrolysierbares Silan allein oder in Kombination mit weiteren hydrolysierbaren Silanen, wobei das hydrolysierbare Silan mindestens eine nicht hydrolysierbare Gruppe umfassend mindestens ein Fluoratom enthält, beschichtet wurde. Dies kann beispielsweise ein Silan mit einer nicht hydrolysierbaren Gruppe mit mindestens einem Fluoratom sein. Solche Silane sind zum Beispiel beschrieben in WO 92/21729 A1. Beispiele sind hydrolysierbare Silane der allgemeinen Formel:

Rf(R)_{b}SiX_{(3-b)} (I)

Wobei X gleich oder verschieden eine hydrolysierbare Gruppe und R gleich oder verschieden ein Alkylsubstituent ist und b den Wert 0, 1 oder 2 hat.

Geeignete Beispiele für hydrolytisch abspaltbare Gruppen X der obigen Formel sind Wasserstoff, Halogen (F, Cl, Br oder I, insbesondere Cl oder Br), Alkoxy (z.B. C₁₋₆- Alkoxy, wie z.B. Methoxy, Ethoxy, n-Propoxy, i-Propoxy und n-, i-, sek.- oder tert.-Butoxy), Aryloxy (vorzugsweise C₆₋₁₀-Aryloxy, wie z.B. Phenoxy), Alkaryloxy, z.B. Benzoyloxy, Acyloxy (z.B. C₁₋₆-Acyloxy, vorzugsweise C₁₋₄-Acyloxy, wie z.B. Acetoxy oder Propionyloxy) und Alkylcarbonyl (z.B. C₂₋₇-Alkylcarbonyl wie Acetyl). Ebenfalls geeignet sind NH₂, mit Alkyl, Aryl und/oder Aralkyl mono- oder disubstituiertes Amino, wobei Beispiele für die Alkyl-, Aryl und/oder Aralkylreste die nachstehend für R angegebenen sind, Amido wie Benzamido oder Aldoxim- oder Ketoximgruppen. Zwei oder drei Gruppen X können auch miteinander verbunden sein, z.B. bei Si-Polyolkomplexen mit Glycol, Glycerin oder Brenzcatechin. Die genannten Gruppen können gegebenenfalls Substituenten, wie Halogen, Hydroxy, Alkoxy, Amino oder Epoxy, enthalten. Bevorzugte hydrolytisch abspaltbare Reste X sind Halogen, Alkoxygruppen und Acyloxygruppen. Besonders bevorzugte hydrolytisch abspaltbare Reste sind C₁₋₄-Alkoxygruppen, insbesondere Methoxy und Ethoxy.

Die hydrolytisch nicht abspaltbaren Reste R der Formel (I) sind z.B. Alkyl (z.B. C₁₋₂₀-Alkyl, insbesondere C₁₋₄-Alkyl, wie Methyl, Ethyl, n-Propyl, i-Propyl, n-Butyl, i-Butyl, sek.-Butyl und tert.-Butyl), Alkenyl (z.B. C₂₋₂₀-Alkenyl, insbesondere C₂₋₄-Alkenyl, wie Vinyl, 1-Propenyl, 2-Propenyl und Butenyl), Alkinyl (z.B. C₂₋₂₀-Alkinyl, insbesondere C₂₋₄-Alkinyl, wie Ethinyl oder Propargyl), Aryl (insbesondere C₆₋₁₀-Aryl, wie Phenyl und Naphthyl) und entsprechende Aralkyl- und Alkarylgruppen, wie ToIyI und Benzyl, und cyclische C₃-C₁₂-Alkyl- und - Alkenylgruppen, wie Cyclopropyl, Cyclopentyl und Cyclohexyl.

Die Reste R können übliche Substituenten aufweisen, bei denen es sich um funktionelle Gruppen handeln kann, über die nach Bedarf auch eine Vernetzung des Kondensats über organische Gruppen möglich ist. Übliche Substituenten sind z.B. Halogen (z.B. Chlor oder Fluor), Epoxid (z.B. Glycidyl oder Glycidyloxy), Hydroxy, Ether, Ester, Amino, Monoalkylamino, Dialkylamino, gegebenenfalls substituiertes Anilino, Amid, Carboxy, Alkenyl, Alkinyl, Acryl, Acryloxy, Methacryl, Methacryloxy, Mercapto, Cyano, Alkoxy, Isocyanato, Aldehyd, Keto, Alkylcarbonyl, Säureanhydrid und Phosphorsäure. Diese Substituenten sind über zweiwertige Brückengruppen, insbesondere Alkylen-, Alkenylenoder Arylen-Brückengruppen, die durch Sauerstoffoder -NH-Gruppen unterbrochen sein können, an das Siliciumatom gebunden. Die Brückengruppen enthalten z. B. 1 bis 18, vorzugsweise 1 bis 8 und insbesondere 1 bis 6 Kohlenstoffatome. Die genannten zweiwertigen Brückengruppen leiten sich z.B. von den oben genannten einwertigen Alkyl-, Alkenyloder Arylresten ab. Natürlich kann der Rest R auch mehr als eine funktionelle Gruppe aufweisen.

Rf ist eine nicht hydrolysierbare Gruppe, die 1 bis 30 Fluoratome an Kohlenstoffatome gebunden aufweist, die vorzugsweise durch mindestens 2 Atome, vorzugsweise eine Ethylengruppe, von Si getrennt sind. Die Gruppe Rf weist bevorzugt 1 bis 25, insbesondere 3 bis 18 Fluoratome auf, welche bevorzugt an aliphatische Kohlenstoffatome gebunden sind. Rf ist bevorzugt eine fluorierte Alkylgruppe mit 3 bis 20 Kohlenstoffatomen. Beispiele für Rf sind CF₃CH₂CH₂-, C₂F₅CH₂CH₂-, n-C₆F₁₃CH₂CH₂-, i-C₃F₇OCH₂CH₂CH₂-, n-C₈F₁₇CH₂CH₂- und n-C₁₀F₂₁-CH₂CH₂-.

Beispiele für geeignete fluorierte Silanverbindungen sind CF₃CH₂CH₂SiCl₂(CH₃), CF₃CH₂CH₂SiCl(CH₃)₂, CF₃CH₂CH₂Si(CH₃)(OCH₃)₂, C₂F₅-CH₂CH₂-SiZ₃, n-C₆F₁₃-CH₂CH₂SiZ₃, n-C₈F₁₇-CH₂CH₂-SiZ₃, n-C₁₀F₂₁-CH₂CH₂SiZ₃ mit (Z = OCH₃, OC₂H₅ or Cl), i-C₃F₇O-CH₂CH₂CH₂-SiCl₂(CH₃), n-C₆F₁₃-CH₂CH₂-Si (OCH₂CH₃)₂, C₆F₁₃-CH₂CH₂-SiCl(CH₃)₂ and n-C₆F₁₃-CH₂CH₂-SiCl₂(CH₃).

Die inerte Oberfläche beeinflusst das Benetzungsverhalten der Oberfläche. Wird nun die Zusammensetzung umfassend Nanodrähte mit dieser Oberfläche in Kontakt gebracht, so kommt es zu einer strukturtreuen Anlagerung der Nanodrähte.

In diesem Verfahren umfasst die Zusammensetzung bevorzugt Nanodrähte, die einen mittleren Durchmesser von unter 50 nm aufweisen, insbesondere unter 40 nm. Bevorzugt ist ein mittlerer Durchmesser von über 0,5 nm, insbesondere über 1 nm, bevorzugt von 3 bis 30 nm, insbesondere von 5 bis 20 nm, ganz besonders bevorzugt 15 nm. Die Länge der Nanodrähte liegt dabei über 1 µm, insbesondere über 2 µm, bevorzugt bei 3 µm bis 200 µm, besonders bevorzugt bei 4 bis 130 µm.

Als Lösungsmittel können die gleichen Lösungsmittel wie für die erste Ausführungsform der Erfindung verwendet werden.

Durch die Verwendung einer inerten Oberfläche verändert sich die Art der Anlagerung. Bei der Entfernung des Lösungsmittels in Kombination mit der Oberfläche kommt es zu Bildung von ineinander verwobenen Strukturen aus den Nanodrähten entlang der Strukturierung. Abhängig von der verwendeten Konzentration der Nanodrähte kann die Höhe der Strukturen beeinflusst werden.

Insbesondere Nanodrähte mit einem mittleren Durchmesser von 3 bis 30 nm und einer Länge von 4 µm bis 130 µm neigen dabei weniger zur Ausbildung von parallelen Anlagerungen, sondern wahrscheinlich aufgrund der Oberflächenspannung und der schlechten Benetzbarkeit der inerten Oberfläche durch die Zusammensetzung kommt es zur Ausbildung der verwobenen Strukturen.

Die Nanodrähte sind dabei nur zu geringem Teil parallel zur Oberfläche angeordnet, sondern füllen den Zwischenraum der Struktur durch eine Struktur aus verwobenen Nanodrähten. Auch dazu ist eine gewisse Biegsamkeit der Nanodrähte erforderlich.

Um die Bildung der verwobenen Struktur zu ermöglichen, kann es vorteilhaft sein, dass die erzeugte Strukturierung eine minimale laterale Ausdehnung von 0,2 µm aufweist.

In einer bevorzugten Ausführungsform der Erfindung, umfasst die Strukturierung Strukturen mit einer minimalen lateralen Ausdehnung von unter 1 µm (gemessen mit AFM und SEM). Dies bedeutet, dass die hergestellten Strukturen auf dem Substrat eine minimale Breite von 20 µm aufweisen, bevorzugt ist eine minimale Ausdehnung von unter 10 µm, insbesondere unter 5 µm.

In einer bevorzugten Ausführungsform umfasst die Strukturierung Linien oder Gitter.

Ein besonderer Vorteil des erfindungsgemäßen Verfahrens liegt darin, dass die verwendete Zusammensetzung auf einfache Weise auf die Substrate aufgetragen werden können. Dabei ermöglicht die Verwendung der Nanodrähte die Herstellung von besonders feinen, insbesondere leitfähige, Strukturen in nur wenigen Schritten. Zum Einsatz kommen zu diesem Zweck alle bekannten Druckverfahren, wie der Tintenstrahldruck, der Tiefdruck, der Siebdruck, der Offsetdruck oder der Hoch- und Flexodruck. Oftmals werden für den Druck der elektrischen Funktionalitäten auch Kombinationsdrucke der vorab erwähnten Druckverfahren eingesetzt. Es kann nötig sein, die verwendeten Druckplatten, - walzen oder Stempel an die Eigenschaften der Zusammensetzungen anzupassen, beispielsweise durch Anpassung ihrer Oberflächenenergie.

Bei den durch Strukturierung erhaltenen Strukturen gibt es eigentlich keine Beschränkung, soweit sie durch Nanodrähte dargestellt werden können. So können bevorzugt aus verzweigten oder unverzweigten Linien bestehende Strukturen, wie Leiterbahnen oder Gitter aufgetragen werden. Aufgrund der guten Auflösung ist es mit dem Verfahren möglich, für das Auge nicht sichtbare leitfähige Strukturen aufzutragen. Dies spielt bei der Herstellung von Oberflächen für Touch-Screens eine große Rolle.

Die Strukturierung durch das Aufbringen der Strukturvorlage kann sogar in übliche Druckverfahren integriert werden, indem die Strukturvorlage die Druckvorlage ersetzt.

Die Erfindung betrifft außerdem ein beschichtetes Substrat erhalten nach dem erfindungsgemäßen Verfahren.

Die Erfindung betrifft außerdem ein strukturiertes Substrat, welches auf der Oberfläche eine Struktur aus Nanodrähten umfasst.

Die Strukturen sind metallische Strukturen, insbesondere umfassen sie die Metalle Kupfer, Silber, Gold, Nickel, Zink, Aluminium, Titan, Chrom, Mangan, Wolfram, Platin oder Palladium, bevorzugt Silber oder Gold.

In einer besonders vorteilhaften Weiterbildung der Erfindung weist das beschichtete Substrat metallische Strukturen auf, welche mindestens teilweise transparent sind. Dies kann beispielsweise durch das Aufbringen von Strukturen mit einer Auflösung von unter 20 µm auf ein transparentes Substrat erreicht werden, bevorzugt unter 10 µm. Es können auch Strukturen mit einer Auflösung von unter 5 µm oder sogar 1 µm sein. Dabei bedeutet Auflösung, dass die Struktur Strukturen mit einer minimalen Ausdehnung von unter der genannten Auflösung aufweist. Dies sind beispielsweise verzweigte oder unverzweigte Linien mit einer Breite der genannten Auflösung, wobei zwischen den Linien ein maximaler Abstand von mindestens einer Linienbreite, insbesondere mindestens der dreifachen Linienbreite, besteht. Die beschichteten Substrate, welche mit dem erfindungsgemäßen Verfahren erhalten werden, können für viele Anwendungen eingesetzt werden. Zum einen eignet sich das Verfahren zum Aufbringen von reflektierenden Metallschichten auf Oberflächen. Diese können beispielsweise als reflektierende Schichten in holographischen Anwendungen verwendet werden.

Ein besonderer Vorteil der Erfindung liegt in der Herstellung von leitfähigen Strukturen. Diese eignen sich als Leiterbahnen in elektronischen Anwendungen, in Touch-Screen-Displays, Solarkollektoren, Displays, als RFID-Antenne oder in Transistoren. Sie eignen sich daher als Ersatz in Produkten, welche bisher auf ITO (Indiumzinnoxid) Basis hergestellt wurden, wie beispielsweise in TCO-Beschichtungen (TCO: transparent conductive oxide).

Die Strukturen können aber auch im Bereich von Transistoren eingesetzt werden.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.

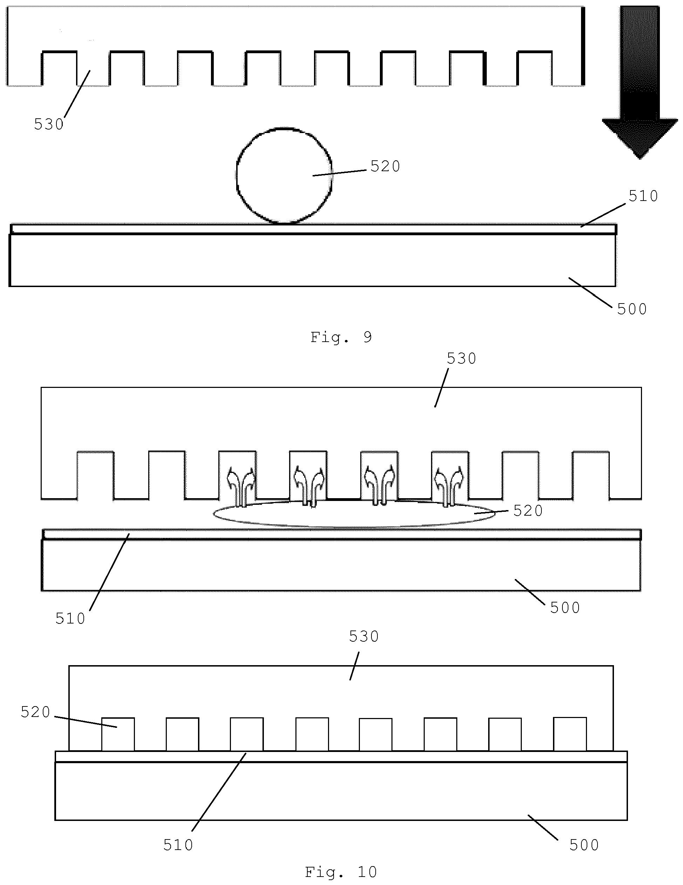

Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente. Die in den Figuren 9-14 dargestellten Verfahren gehören nicht zur Erfindung dienen aber ihrer Veranschaulichung. Im Einzelnen zeigt:
- Fig. 1: a) TEM-Aufnahme von Goldnanodrähten; b) TEM-Aufnahme von Goldnanodrähten; c) SEM-Aufnahme des verwendeten Stempels.
- Fig. 2: Schematischer Ablaufplan des erfindungsgemäßen Verfahrens mit Nanodrähten;
- Fig. 3: Schematische Darstellung eines Ablaufs des erfindungsgemäßen Verfahrens mit Nanodrähten;
- Fig. 4: Schematische Darstellung eines Ablaufs des erfindungsgemäßen Verfahrens mit Nanodrähten;
- Fig. 5: SEM-Aufnahmen von zwei erhaltenen strukturierten Beschichtungen; a) mit einer durchschnittlichen Dicke von 15 nm; b) mit einer durchschnittlichen Dicke von 45 nm; Die kleinen Figuren zeigen einen vergrößerten Ausschnitt der jeweiligen SEM-Aufnahme;
- Fig. 6: a) Transmissionsspektren von erhaltenen strukturierten Beschichtungen (NM-15nm: Struktur aus Figur 4a; NM-45nm: Struktur aus 4b); b) Leitfähigkeitsmessungen (NM-15nm: Struktur aus Figur 4a; NM-45nm: Struktur aus 4b) ;
- Fig. 7: Gemessene Veränderung der Widerstands eines erfindungsgemäßen Gitters (AuNM) und eines kommerziellen Gitters aus ITO (ITO on PET) beim Biegen des Substrats;
- Fig. 8: TEM-Aufnahme eines gebogenen Goldnanodrahts;
- Fig. 9: Schematische Darstellung eines Verfahrens mit inerter Oberfläche;
- Fig. 10: Schematische Darstellung eines Verfahrens mit inerter Oberfläche;
- Fig. 11: Schematische Darstellung einer weiteren Ausführungsform eines Verfahrens mit inerter Oberfläche;

- Fig. 12: Schematische Darstellung einer weiteren Ausführungsform eines Verfahrens mit inerter Oberfläche;
- Fig. 13: Schematische Darstellung einer weiteren Ausführungsform eines Verfahrens mit inerter Oberfläche;
- Fig. 14: Schematische Darstellung einer weiteren Ausführungsform eines Verfahrens mit inerter Oberfläche;

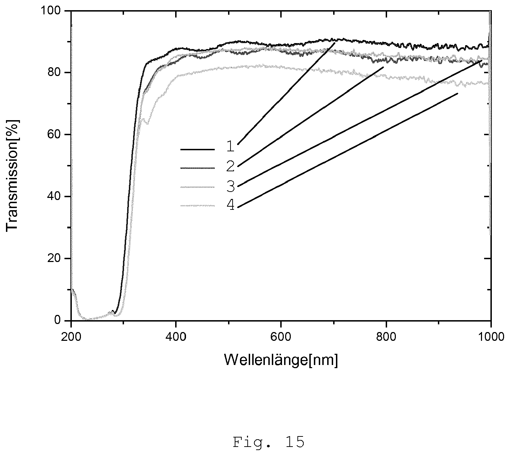

- Fig. 15: Messung der Transmission von verschiedenen Proben (1: Gitterstruktur Variante 1; 2: Gitterstruktur Variante 2; 3: Nanodrähte flächig; 4: Nanodrähte flächig dicht gepackt);

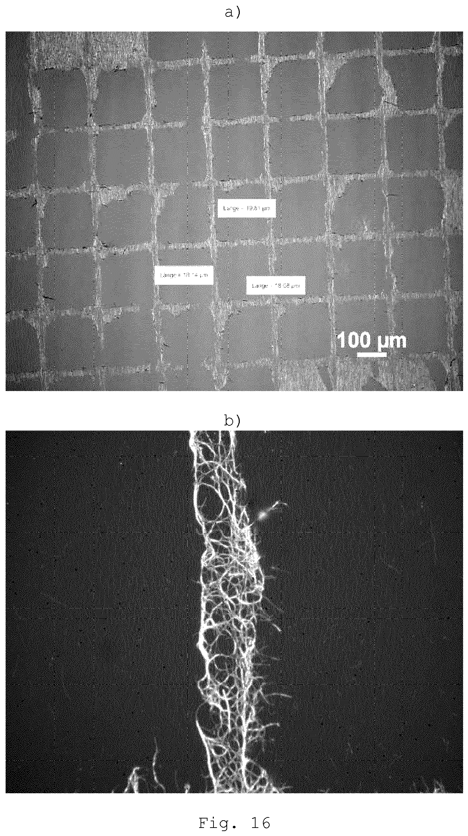

- Fig. 16: SEM-Aufnahme der erhaltenen Gitterstruktur nach Variante 1 (a) Gesamtaufnahme; b) Struktur in größerer Auflösung; Strukturbreite 18,68µm +/- 0,98µm);

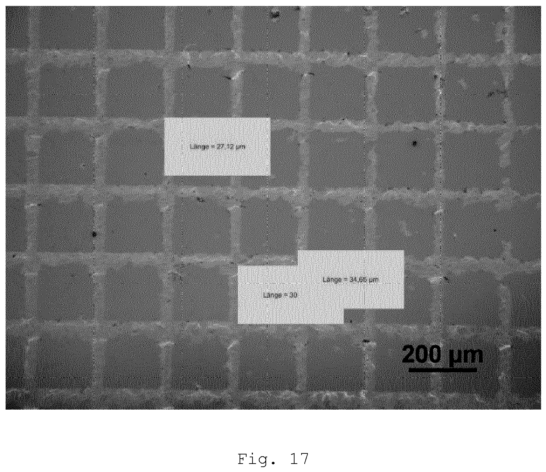

- Fig. 17: SEM-Aufnahme der erhaltenen Gitterstruktur nach Variante 2 (Strukturbreite 30,59µm +/- 3,8µm);

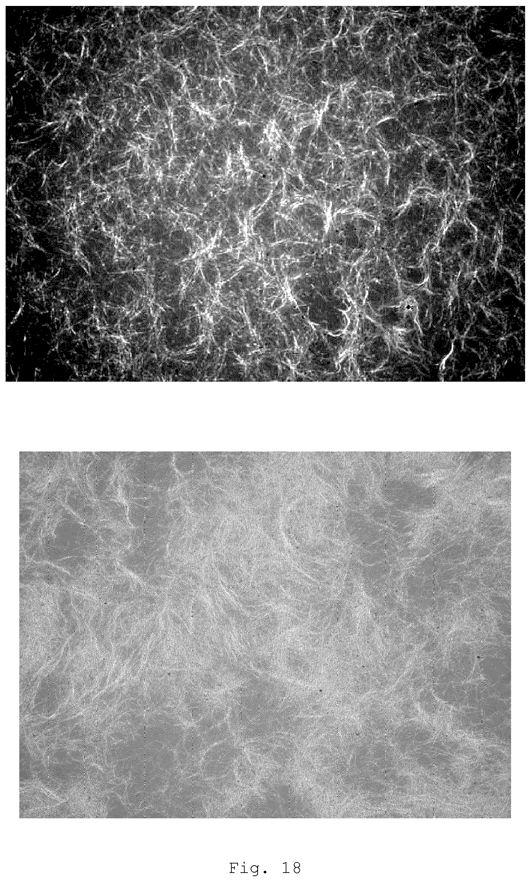

- Fig. 18: SEM-Aufnahme der Silbernanodrähte flächig;
- Fig. 19: SEM-Aufnahme von kommerziell erhältlichen Silbernanodrähten nach Strukturierung (Vergleichsbeispiel);
- Fig. 20: SEM-Aufnahme von kommerziell erhältlichen Silbernanodrähten nach Strukturierung (Vergleichsbeispiel).

### I. Strukturierung durch Anlagerung

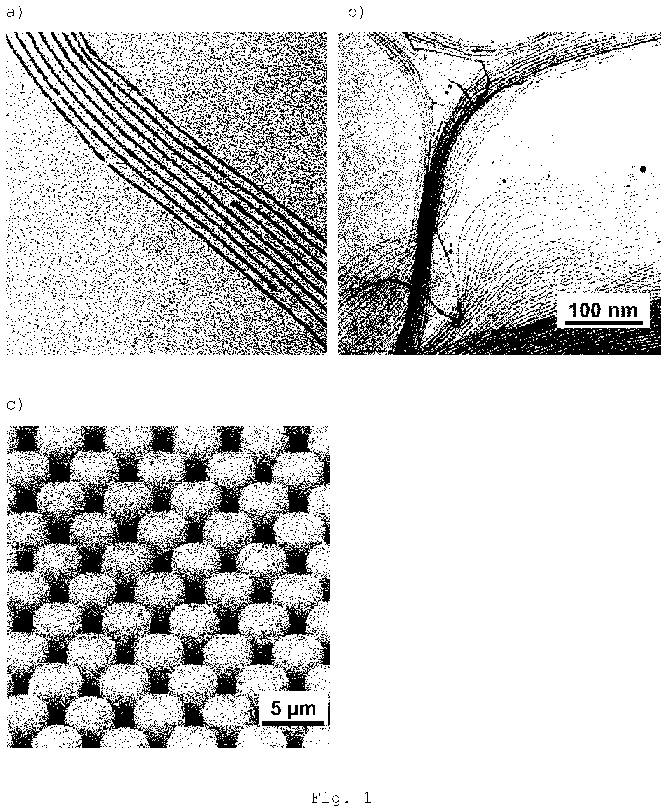

Figur 1 zeigt TEM-Aufnahmen von Goldnanodrähten. Die Nanodrähte haben bei einem Durchmesser von unter 2 nm eine Länge von weit über 500 nm. In a) und b) ist gut zu erkennen, wie sich die Nanodrähte schon von sich aus zu Bündeln zusammenlagern. Figur 1 c) zeigt einen der verwendeten Stempel.

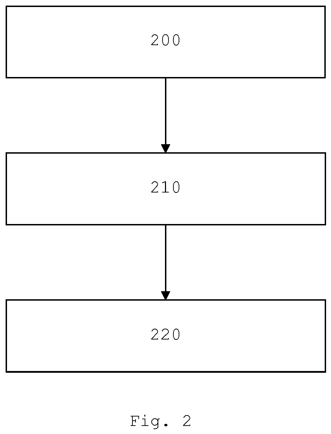

Figur 2 zeigt eine schematische Darstellung des Ablaufs eines erfindungsgemäßen Verfahrens. Dabei wird zunächst die Zusammensetzung auf die Oberfläche aufgetragen (200). Danach werden die Nanodrähte in der Zusammensetzung strukturiert (210). Dies geschieht bevorzugt durch Aufbringen einer Strukturvorlage unter teilweiser Verdrängung der Zusammensetzung. Danach wird das Lösungsmittel mindestens teilweise entfernt (220).

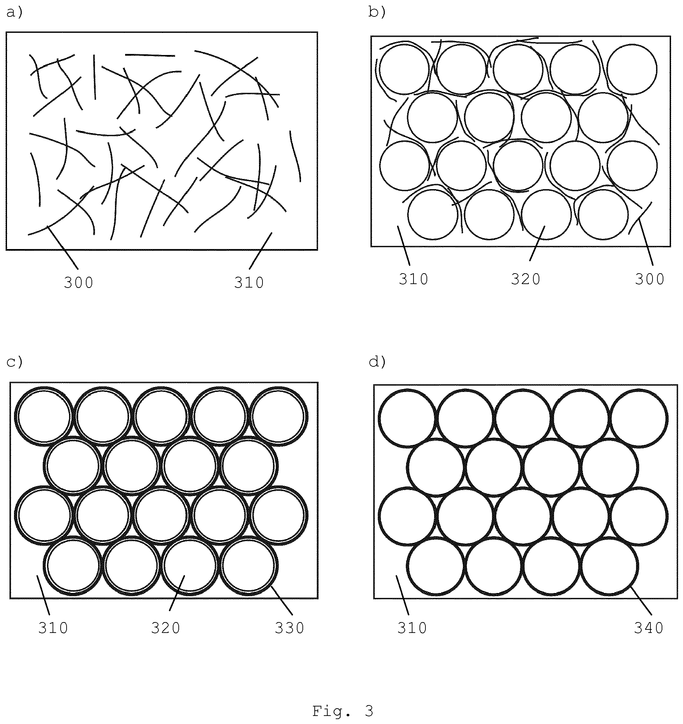

Figur 3 stellt eine erfindungsgemäße Ausführungsform des Verfahrens dar. Wie in Figur 3 a) gezeigt sind nach dem Auftragen der Zusammensetzung die Nanodrähte 300 zufällig auf der Oberfläche des Substrate 310 angeordnet. Sie sind dabei noch in einem Lösungsmittel dispergiert. Danach wird eine Strukturvorlage, bevorzugt in Form eines Stempels 320 auf die Oberfläche 310 aufgebracht (Figur 3 b)). In diesem Fall umfasst der Stempel zylindrische Vorsprünge mit planaren Stirnflächen (Ähnlich Figur 1 c)). Diese bilden eine Kontaktfläche mit der Oberfläche des Substrats 310. Dadurch wird in diesen Bereichen die Zusammensetzung verdrängt. Die Nanodrähte werden dadurch in die Zwischenräume zwischen den Vorsprüngen transferiert. Dann wird das Lösungsmittel mindestens teilweise entfernt. Dies kann beispielsweise dadurch gewährleistet werden, dass die Vorsprünge des Stempels höher sind, als die Dicke der aufgetragenen Zusammensetzung. Dadurch bildet sich oberhalb der Zusammensetzung ein Hohlraum durch den das Lösungsmittel verdunsten kann. Durch die lokale Erhöhung der Konzentration der Nanodrähte kommt es zur Bildung von Bündeln an Nanodrähten 330. Diese lagern sich bevorzugt zwischen den Vorsprüngen 320 auf dem Substrat 310 an (Figur 3 c)). Nach Entfernung der Strukturvorlage bleibt auf der Oberfläche des Substrats 310 eine aus den Nanodrähten gebildete Struktur 340 zurück (Figur 3 d)). Gegebenenfalls kann es erforderlich sein durch eine Nachbehandlung die organischen Bestandteile der Struktur zu entfernen, dies kann beispielsweise durch eine Plasmabehandlung geschehen.

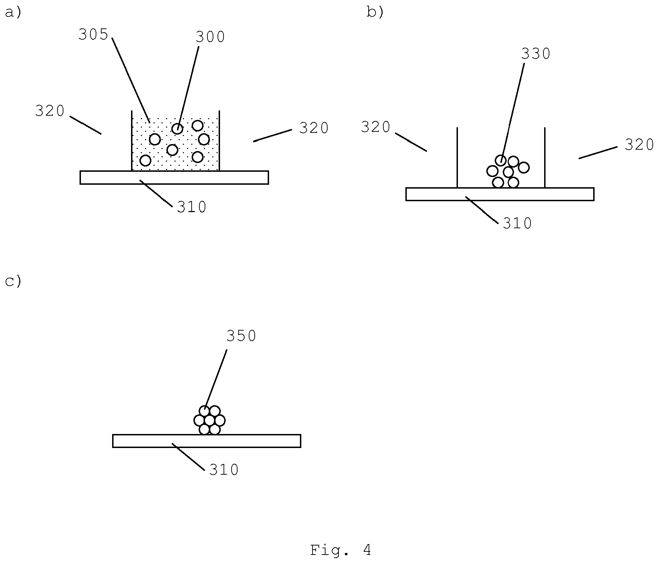

Figur 4 zeigt die Abläufe des in Figur 3 dargestellten Verfahrens als Darstellung im senkrechten Querschnitt. In Figur 4 a) ist die Situation von Figur 3 b) im senkrechten Querschnitt dargestellt. Zwischen den beiden Vorsprüngen 320, welche in Kontakt mit der Oberfläche des Substrats 310 stehen, ist die aufgetragene Zusammensetzung angeordnet. Diese umfasst in diesem Fall ein Lösungsmittel 305 und den darin dispergierten Nanodrähten 300, welche hier als runder Querschnitt dargestellt sind. Die Darstellung bedeutet nicht, dass die Nanodrähte vollständig dispergiert vorliegen. Es kann durchaus sein, dass sie schon in der Dispersion teilweise aneinander angelagert vorliegen und so schon erste Bündel gebildet haben. Im nächsten Schritt wird das Lösungsmittel 305 entfernt. Die Nanodrähte 330 im Zwischenraum zwischen den Vorsprüngen 310 lagern sich nun zu Bündeln auf der Oberfläche 310 zusammen. Dies wird auch dadurch begünstigt, dass die Nanodrähte sehr lang und biegsam sind.

Nach Entfernung des Stempels kann noch ein Sinterschritt durchgeführt werden (Figur 4c)). Dabei wird beispielsweise durch eine Plasmabehandlung die organische Hülle der Nanodrähte entfernt und die Bündel der Nanodrähte weiter verdichtet. Dadurch kann die Leitfähigkeit der Nanodrahtbündel 350 erhöht werden. In den Figuren 9, 10, 11, 12, 13 und 14 sind weitere Ausführungsformen dargestellt.

Figur 9 zeigt ein Substrat 500, auf dessen Oberfläche eine inerte Schicht 510 aufgebracht ist. Auf dieser ist die Zusammensetzung 520 umfassend Nanodrähte angeordnet. Auf diese Oberfläche wird eine Strukturvorlage in Form eines Stempels 530 aufgebracht. Die Vorgänge dabei sind in Figur 10 dargestellt. Die Zusammensetzung 520 wird durch die Vorsprünge der Strukturvorlage 530 in die Zwischenräume zwischen den Vorsprüngen verdrängt (oberer Teil der Abbildung). Dies wird durch die inerte Oberfläche 510 auf dem Substrat 500 begünstigt. Wenn die Vorsprünge der Strukturvorlage 530 mit dem Substrat 500, bzw. mit der inerten Oberfläche 510 in Kontakt getreten sind, ist die gesamte Zusammensetzung 520 in den Vertiefungen der Strukturvorlage angeordnet (Figur 10 unterer Teil der Abbildung).

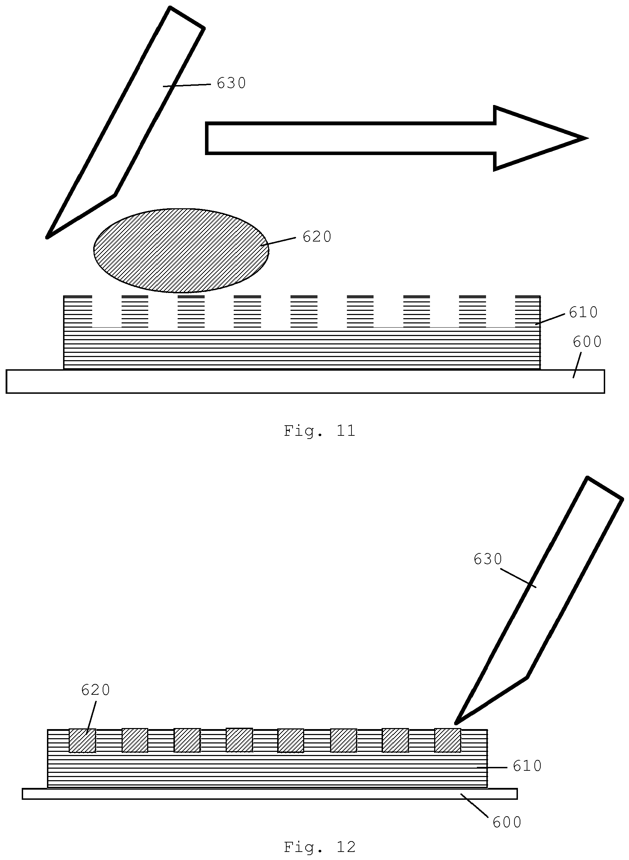

Die Figuren 11 bis 14 zeigen eine andere Ausführungsform. Dazu wird die Zusammensetzung umfassend die Nanodrähte 620 auf eine Strukturvorlage 610 gegeben, welche auf einem Träger 600 angeordnet sein kann (Figur 11). Mit einer Rakel 630 wird die Zusammensetzung in die Vertiefungen der Strukturvorlage gedrückt. Die dadurch erhaltene "gefüllte" Strukturvorlage 610, bei der die Vertiefungen mit Zusammensetzung 620 gefüllt sind ist in Figur 12 gezeigt. Die Strukturvorlage kann auf einem Träger 600 angeordnet sein.

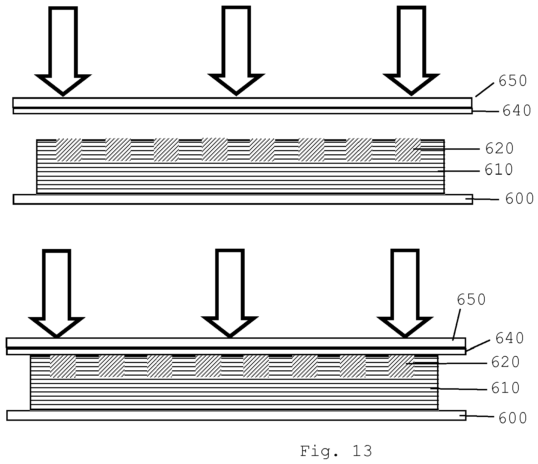

Wie in Figur 13 gezeigt kann nun diese gefüllte Strukturvorlage 610 mit der Zusammensetzung 620 in den Zwischenräumen mit einer inerten Oberfläche 640 auf einem Substrat 650 in Kontakt gebracht werden (unterer Teil der Abbildung).

Um die Struktur auf der inerten Oberfläche zu erzeugen, wird die Strukturvorlage zusammen mit der inerten Oberfläche gedreht, so dass die inerte Oberfläche unten angeordnet ist. Dadurch können sich die Nanodrähte auf der inerten Oberfläche anlagern.

Man erhält im Prinzip die gleiche Anordnung, wie im unteren Teil der Figur 10 gezeigt.

Unabhängig von der Art der Präparation der Anordnung wird nun das Lösungsmittel der Zusammensetzung in dieser Anordnung mindestens teilweise entfernt. Dadurch kann das Anlagern der Nanodrähte auf der inerten Oberfläche begünstigt werden.

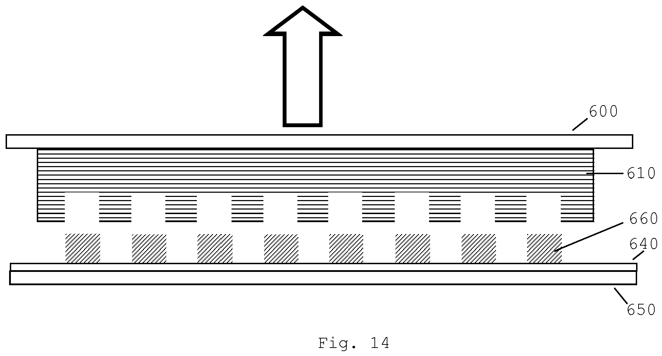

Danach wird wie in Figur 14 gezeigt, die Strukturvorlage 610 entfernt. Man erhält eine metallische Struktur 660 auf der inerten Oberfläche 640.

### I.1. Beispiele

Die TEM-Aufnahmen wurden mit einem JEM 2010 (JEOL, Deutschland) bei 200 kV aufgenommen. Die SEM-Aufnahmen wurden mit einem Quanta 400 ESEM (FEI, Deutschland) aufgenommen. Optische Messungen wurden mit einem Cary 5000 (Varian) aufgenommen. Das Spektrum des Glassubstrates wurde als Basislinie genommen. Die Strom/Spannung-Messungen wurden mit einem Keithley 2450 Sourcemeter durchgeführt.

Die Goldnanodrähte wurden analog zu H. Feng, Y. Yang, Y. You, G. Li, J. Guo, T. Yu, Z. Shen, T. Wu, B. Xing, Chem. Commun. 2009, 1984 und J. H. M. Maurer, L. Gonzälez-Garcia, B. Reiser, I. Kanelidis, T. Kraus, ACS Appl. Mater. Interfaces 2015, 7, 7838 hergestellt.

Dazu wurden 30 mg HAuCl₄xH₂O in einer Mischung aus 5,8 ml n-Hexan (99%, ABCR, Germany) und 1,7 ml Oleylamine ((Z)-Octadec-9-enylamine technisch, 70%, Sigma-Aldrich, Steinheim, Deutschland) gelöst. 1,5 ml Triisopropylsilan (98%, ABCR, Deutschland) wurden zugegeben und die Lösung über Nacht bei Raumtemperatur stehen gelassen. Die Nanodrähte wurden durch die Zugabe von Ethanol ausgefällt. Der Überstand wurde entfernt und die Nanodrähte in n-Hexan redispergiert. Der Waschschritt wurde einmal wiederholt und die Nanodrähte danach in Cyclohexan redispergiert, um Lösungen mit einer Goldkonzentration von 4 mg/ml, bzw. 8 mg/ml, zu erhalten.

30 µl einer Zusammensetzung aus Goldnanodrähten dispergiert in Cyclohexan (4 mg/ml, 8 mg/ml) wurde auf ein Substrat gegeben. Danach wurde ein strukturierter Stempel aus PDMS sofort auf das Substrat gedrückt. Die Zusammensetzung wird dadurch in die Vertiefungen des Stempels gedrückt. Der Stempel umfasste eine hexagonale Anordnung von zylindrischen Vorsprüngen mit 4 µm Durchmesser und einem Abstand der Vorsprünge von 5 µm (Mittelpunkt zu Mittelpunkt). Die Höhe der Vorsprünge betrug 5 µm. Bei dem Verdampfen des Lösungsmittels bilden sich Bündel der Goldnanodrähte in den Vertiefungen, welche die Struktur der Vertiefungen nachbilden. Nach Entfernung des Stempels wurde die Struktur für 15 Minuten bei Raumtemperatur mit einem Wasserstoffplasma (Mischung aus 5 % Wasserstoff in Argon) behandelt (RF PICO plasma system (Diener electronic, Ebhausen, Deutschland) 0,3 mbar, 100 W).

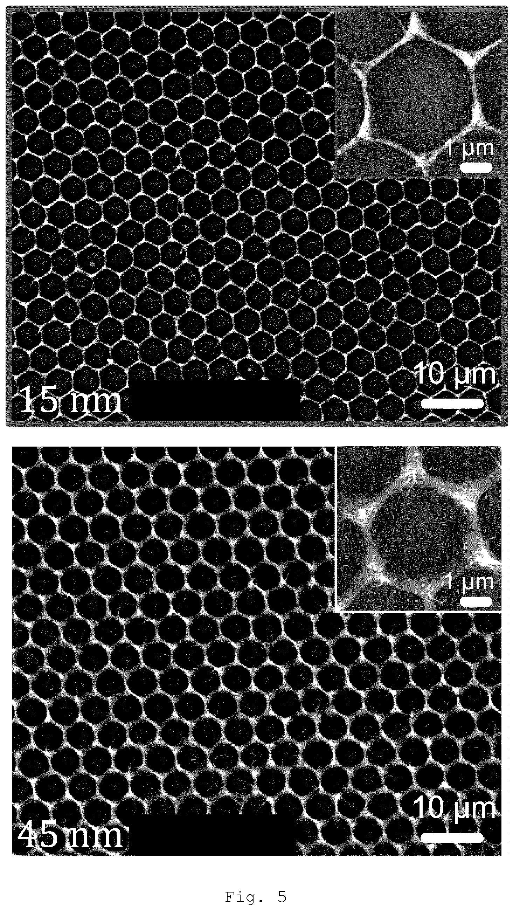

Abhängig von der Konzentration der Goldnanodrähte in der Zusammensetzung konnte die Dicke der erhaltenen Strukturen gesteuert werden. Bei Verwendung einer Konzentration von 4 mg/ml wurde eine Struktur mit einer durchschnittlichen Dicke von 15 nm erhalten. Die minimale Breite betrug 250 nm (Figur 5 a)). Bei Verwendung von 8 mg/ml konnte eine Struktur mit einer durchschnittlichen Dicke von 45 nm und eine minimalen Breite von 600 nm (Figur 5 b)) erhalten werden. Dabei entspricht die minimale Breite die minimale im Bereich des SEM gefundene Breite der Struktur.

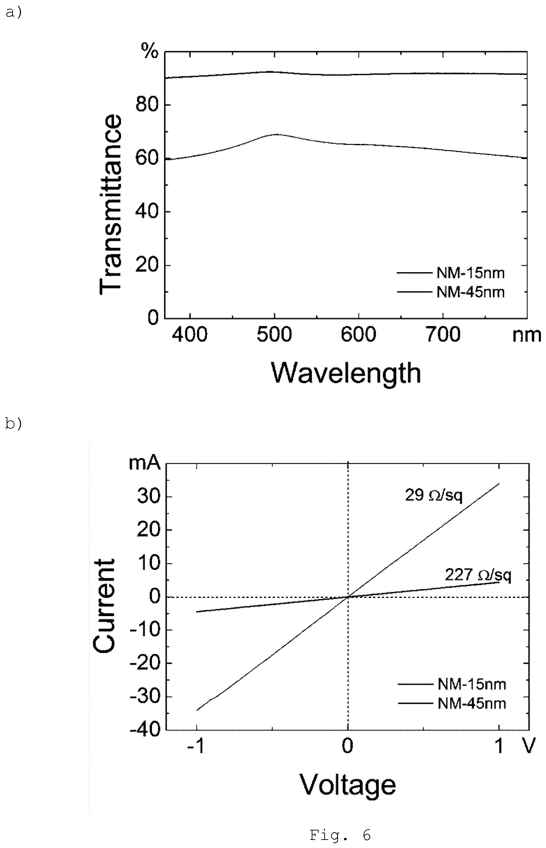

Figur 6 a) zeigt Transmissionsspektren der erhaltenen Gitter. Das Gitter aus Figur 5 a) zeigte eine hohe Transmission über den gesamten sichtbaren Bereich (obere Linie). Auch das Gitter aus Figur 5 b) zeigt eine hohe Transmission von bis zu 68 % (untere Linie). Die Werte sind in guter Übereinstimmung mit berechneten Werten für ein Gitter mit der gleichen Bedeckung. Als Hazewert wurden 1,6 % (Figur 5a) und 2,7 % (Figur 5b) gemessen. Dies liegt unter dem üblicherweise erforderlichen Wert für Displays (< 3 %).

Figur 6 b) zeigt die zugehörigen Spannung/Strom-Diagramme. Das dünnere Gitter zeigte einen Widerstand von 227 Ω/sq, das dickere Gitter einen Widerstand von 29 Ω/sq. Diese sind zwar höher als die berechneten Werte für Gitter aus reinem Gold (32.5 Ω sq für d=5pm, w=250nm, h=15nm und 4,5 Ω/sq für d=5pm, w=600nm, h=45nm bei einem Widerstand für Gold von 2,44x10⁻⁸ Ωm). Dies kann aber auf Unregelmäßigkeiten im Gitter zurückgeführt werden, beispielsweise durch Korngrenzen nach dem Sintern, sowie nicht verbundene Gitterstege.

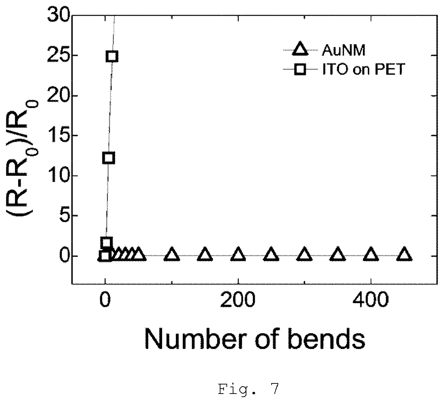

Figur 7 zeigt die Ergebnisse von Biegeversuchen. In der Figur ist die Veränderung des Widerstands gegen den Anfangswiderstand ((R-R₀)R₀) gegen die Anzahl der Biegezyklen aufgetragen. Die Proben wurden unter Spannung mit einem Biegeradius von 5 mm gebogen. Für die Versuche wurden 10 erfindungsgemäße Gitter auf PET mit einem anfänglichen durchschnittlichen Widerstand von 100 Ω/sq verwendet (AuNM) verwendet. Als Vergleichsversuch wurde ein kommerziell erhältliches Gitter aus ITO auf PET mit einem Widerstand von 100 Ω/sq verwendet (ITO on PET, Sigma-Aldrich, R₀=100 Ω/sq). Der Widerstand der Vergleichsprobe stieg nach wenigen Zyklen um mehrere Größenordnungen an. Für die erfindungsgemäßen Gitter war der Anstieg innerhalb der ersten 50 Zyklen unter einer Größenordnung, gefolgt von einem asymptotischen Trend gegen (R-R₀)R₀ = 0,056 nach 450 Zyklen. Die erfindungsgemäßen Gitter sind demnach auch für flexible Substrate geeignet.

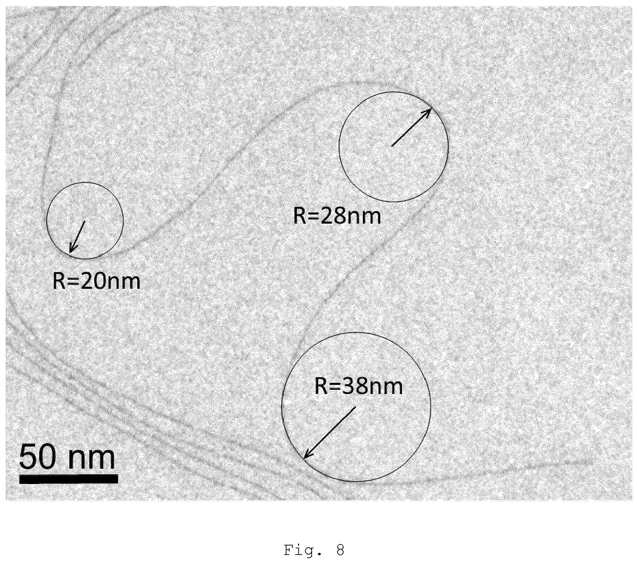

Figur 8 zeigt ein Beispiel für die Biegsamkeit der dünnen Goldnanodrähte. Die R-Werte geben die an die Biegung angepassten Radien der Kreise an. Es konnten Biegeradien von bis zu 20 nm beobachtet werden, ohne dass es zu einem Bruch der Drähte kam.

### I.2. Herstellung des Stempels

Der PDMS-Stempel wurde mit einem Silikon-Templat hergestellt. Das Vorpolymer und der Vernetzer des PDMS-Kits (Sylgard 184, Dow Corning) wurden in einem Verhältnis von 10:1 (Gewicht) gemischt und entgast. Die Mischung wurde in das Templat gefüllt, welches zuvor mit trichloro(octadecyl)silane (Sigma Aldrich, St. Louis, MO, USA) silanisiert wurde, und bei 70 °C ausgehärtet. Danach wurde der Stempel aus dem Templat entfernt.

### I.3. Vergleichsbeispiele

Zusammensetzungen mit kommerziell erhältlichen Silbernanodrähten (Seashell Technology; Durchmesser 130 nm +/- 10 nm; Länge 35 µm +/- 15 µm) wurden analog zu den Beispiele hergestellt und auf Oberflächen aufgebracht. Es zeigt sich, dass es zu keiner Anlagerung kommt. Die Nanodrähte können auch nicht durch Aufbringen eines Stempels verdrängt werden, so dass es nicht zur Ausbildung einer Struktur kommt.

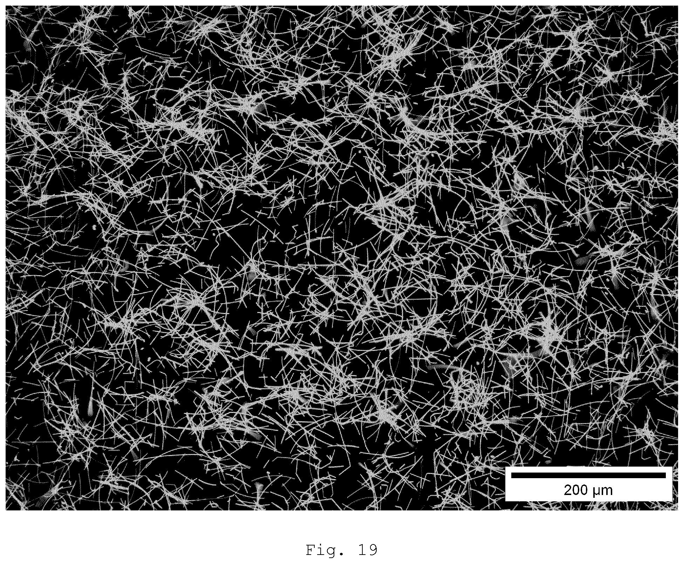

In Figur 19 ist die analoge Durchführung des erfindungsgemäßen Verfahrens mit dem gleichen Stempel gezeigt. Es zeigt sich, dass es zu keiner Strukturierung kommt.

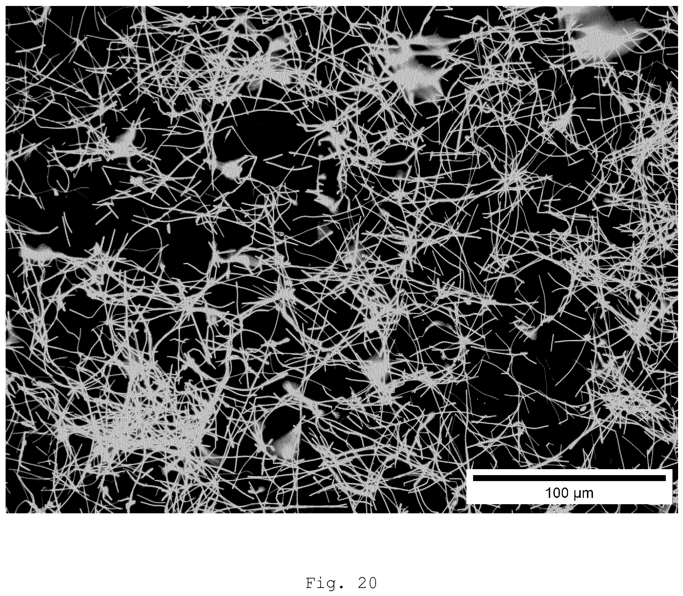

Auch ein größerer Stempel (25 µm Durchmesser der säulenförmigen Vorsprünge mit 50 µm Mittelpunktsabstand) führt nicht zu einer Strukturierung (Figur 20).

### II. Strukturisierung mit Inerter Oberfläche (nicht Teil der Erfindung)

### II.1. Herstellung eines PDMS-Stempels

Im Folgenden wird die Herstellung eines Prägestempels aus PDMS (Silikonkautschuk) als Abguss eines Nickelmasters beschrieben: II.1.A. Beschreibung des Nickelmasters und der Gießform

Bei dem Nickelmaster handelt es sich um eine galvanisch hergestellte Nickelfolie z.B. der Dimension 100 mm x 100 mm, auf die eine Mikrostruktur (regelmäßig angeordnete zylindrische Säulen mit einem Durchmesser von über 1 µm) aufgebracht ist. Diese Nickelfolie wird auf den Boden einer aus Aluminium oder ähnlichem Material hergestellten Gießform aufgeklebt oder mittels ferromagnetischer Klebefolie angebracht. Hierbei ist zu beachten, dass der Nickelmaster absolut plan aufzubringen ist, da sich jede Unebenheit im späteren Stempel wiederfinden wird. Außerdem muss die Gießform auf eine möglichst waagerechte Lage gebracht werden, damit der Prägestempel später eine gleichmäßige Dicke aufweist.

### II.1.B. Mischung des Silikonkautschuks und Formabguss

Basismaterial und Härter eines Polydimethylsiloxans (PDMS) (z. B. Sylgard 184 von Dow Corning)werden in geeigneten Verhältnis (z.B. 10:1) zusammen und mischt beide Komponenten durch Rühren. Die anzusetzende Menge richtet sich nach der gewünschten Dicke des Prägestempels (typische Stempeldicke: 2 bis 4 mm). Das Mischgefäß sollte das 3fache Volumen der Mischung umfassen, um ein Überlaufen beim folgenden Entgasungsvorgang zu verhindern.

Zum Entfernen der beim Rühren eingemischten Luftbläschen bringt man die Mischung in einen Vakuumtrockenschrank (bei Raumtemperatur) und evakuiert so lange, bis sämtliche Luftblasen entfernt sind.

Die entgaste PDMS-Mischung gießt man nun in die Gießform und lässt die Mischung härten. In den meisten Fällen ist es sinnvoll, die Härtung durch eine Temperierung der Gießform zu beschleunigen. Typischerweise führt eine Erwärmung der Gießform auf 70°C über eine Stunde zu einem vollständigen Aushärten des PDMS.

### II.1.C. Entformungsvorgang

Das Entformen des PDMS-Stempels geschieht, indem man mit einem Skalpell oder anderem scharfen Messer das PDMS von der senkrechten Wandung der Gießform über den ganzen Umfang einschneidet und dann mit einem flachen und stumpfen Werkzeug (z. B. flacher Spatel) vom Rand ab hebelt und dann vorsichtig vom Nickelmaster ablöst. Unregelmäßigkeiten am Rand können nun mit einem scharfen Messer (z. B. Teppichmesser) abgeschnitten werden.

### II.2. Funktionalisierung der Substratoberfläche:

Im Folgenden wird die Herstellung des Antihaftbeschichtungsmaterial (hydrophob) beschrieben:

### II.2.A. Lackherstellung

### Einsatzmengen:

| | |
|---|---|
| 267,8 g | Methyltriethoxysilan (MTEOS) |
| 84,8 g | Tetraethoxysilan (TEOS) |
| 150,0 g | Levasil 300/30 |
| 3,0 g | konz. (37%) Salzsäure |
| 13,35 g | Perfluorooctyltriethoxysilan (Dynasylan F 8261) |
| 518,95 g | Isopropanol |

### Durchführung:

In einen 2 l Reaktor (Doppelmantelgefäß mit angeschlossener Kühlung) mit Innenthermometer werden die abgewogenen Mengen MTEOS und TEOS gegeben. Man gibt die abgewogene Menge Levasil zu und lässt kräftig 2-3 min rühren. Dann gibt man die abgewogene Menge konzentrierte Salzsäure hinzu und lässt weiter rühren. Man beobachtet die Reaktionslösung und die Innentemperatur am Thermometer und schreibt die Beobachtung auf. Die Temperatur im Inneren des Reaktors sollte dabei 60°C nicht übersteigen. Nach 10-15 min Rühren gibt man die abgewogene Menge Perfluorooctyltriethoxysilan zu und lässt weitere 30 min rühren. Dann gibt man die abgewogene Menge Isopropanol zu und lässt 15 min rühren. Das Material wird abgefüllt in eine 2 L Glasflasche und anschließend mit Hilfe einer Druckfiltration (Vorfilter+ 0,45pm Filter) filtriert. Der fertige Lack wird abgefüllt in eine 2 L Schottglasflasche und im Kühlschrank bis zur Weiterverarbeitung aufbewahrt.

### II.2.B. Schichtherstellung

Der Lack wurde mittel Spin coating (1000 rpm/min, 30sec) aufgetragen und im Ofen ausgeheizt (Luftatmosphäre; hochheizen innerhalb von 30 min auf 100°C; 30 min halten, aufheizen innerhalb von 240min auf 250°C, 1h halten, abkühlen).

### II.3. Silbernanowire-Lösung

Im Folgenden wird die Aufbereitung einer Silbernanowire-Lösung von Cambrios (Lösungsmittel: Ethylenglycol) für die Schichtherstellung beschrieben:

### II.3.A. Aufreinigung und Lösungsmittelaustausch über Cross-Flow-Filtration

200 ml der Silbernanowire-Lösung in Ethylenglycol werden mit 200 ml reinem H₂O (Millipore) verdünnt und in ein großes Becherglas gefüllt. Mit Hilfe einer Schlauchpumpe (Flussrate 1,2 ml/sec.) wird die Lösung durch eine Filterpatrone gepumpt (Material: PES; Porengröße: 0,5pm; Firma SpectrumLabs; Typ: Microkros 3x 0,5pm PES 1,0mm MLL x FLL Dry (4/PK)). Das abgetrennte Filtrat wird in einem Auffangbehälter gesammelt. Das Retentat wird durch einen Schlauch zurück in das große Becherglas geleitet. Es wird so lange filtriert, bis 200ml Filtrat abgetrennt sind.

Dieses Verfahren wird ein zweites Mal durchgeführt, um so viele störende Silberpartikel wie möglich zu entfernen. Reinheit der Nanowire Lösung >90%.

### II.3.B. Silbergehaltbestimmung der aufgereinigten Nanowire-Lösung in Wasser

Die Probe wird vor der Einwaage aufgeschüttelt von Hand. Die Einwaagen erfolgen in 50ml Glaskolben, anschließend werden die Proben mit 2 ml HNO₃ (65%) versetzt und mit Reinstwasser aufgefüllt. Um Matrixeffekte zu vermeiden, werden die Standards dem Säuregehalt der Proben angepasst. Um die Reproduzierbarkeit zu überprüfen, werden 3 Einwaagen nebeneinander durchgeführt.

### Standards:

Element S0 S1 S2
Ag (mg/l) 0,0 5,0 8,0

### Geräteparameter:

- ICP OES, Horiba Jobin Yvon Ultima 2
- Ag-Bestimmung: Cinical Zerstäuber : Druck: 2,00bar Durchfluss: 0,78l/min
- Ag: λ= 328,068nm

Die Bestimmung ergab einen Silbergehalt von 0,295 Gew.% +/-0,002.

### II.3.C. Erneuter Lösungsmittelaustausch zum Erhalt einer Beschichtungslösung mit anderen Verlaufseigenschaften als die wasserbasierte Silbernanowire-Lösung

5ml der aufgereinigten Silbernanowire-Lösung in Wasser werden mit 2ml 1-Amino-2-butanol, 5µl TODS (3,6,9-Trioxadecansäure) und 10ml Aceton gemischt und zentrifugiert (Geschwindigkeit: rcf= 2000; Dauer: 1min). Der entstandene Überstand wird abdekantiert und der gebildete Bodensatz wird in 10ml 1-Amino-2-butanol redispergiert.

### II.4. Nanoimprint 1

Im Folgenden wird die Herstellung (Variante 1) einer Gitterstruktur aus Silber-Nanowires mit Hilfe eines PDMS-Stempels beschrieben, in der sich die Silber-Nanowires in Gitterlinien anordnen:

### II.4.A. Beschreibung der Aufbereitung der Silber-Nanowirelösung kurz vor Probenherstellung

Das Probengefäß mit der darin befindlichen Nanowire-Lösung wird mit Hilfe eines Vortexer (Firma Heidolph, Typ Reax control, Speed 2500rpm)kurz vor der Probenherstellung aufgeschüttelt um den Bodensatz wieder zu dispergieren.

### II.4.B. Beschichtungsvorgang

Ein Glassubstrat (Größe 10cm x 10cm x 0,11cm), beschichtet mit dem Antihaftbeschichtungsmaterial (siehe Punkt II.2.), wird plan auf einem Labortisch aufgelegt. Es wird mittig ein Tropfen (Volumen 20µl) der aufbereiteten Nanowire-Lösung aufgetragen.

Ein strukturierter PDMS-Stempel (Herstellung beschrieben unter Punkt 1) wird so von Hand aufgedrückt, dass sich die Lösung gleichmäßig unter dem Stempel verteilt und überschüssiges Material verdrängt wird.

Um das überschüssige Lösungsmittel abzudampfen wird die Probe (Substrat + Stempel) auf eine Heizplatte gelegt und auf 50°C erwärmt. Während dieses Prozesses wird auf den PDMS-Stempel eine Metallplatte (Gewicht 800g) aufgelegt, um eine optimale, gleichmäßige Haftung des Stempels auf dem Substrat zu gewährleisten. Nach 15min wird das Probenpaket (Substrat→ Stempel → Metallplatte) von der Heizplatte genommen und auf dem Labortisch abkühlen gelassen.

Sobald die Probe abgekühlt ist, wird zuerst die Metallplatte entfernt, mit einer Hand stabilisiert man das Substrat auf der Tischplatte und mit der anderen entfernt man durch abziehen den PDMS-Stempel.

### II.4.C. Beschichtungsvorgang Variante 2

Ein PDMS-Stempel mit Gitterstruktur (Herstellung beschrieben unter Punkt 1, Linienbreite 15µm) wird mit der Rückseite (unstrukturiert) auf ein unbeschichtetes Glassubstrat (Größe 5cm x 5cm x 0,11cm) aufgelegt. Auf die strukturierte Seite des PDMS-Stempels wird am Rand ein Tropfen (Volumen 20µl) der aufbereiteten Nanowire-Lösung aufgetragen.

Mit Hilfe einer Art Rakel (hier eine Rasierklinge) wird der Tropfen Nanowire-Lösung auf der strukturierten Fläche des PDMS-Stempels gleichmäßig verteilt.

Anschließend wird ein beschichtetes Glassubstrat (Größe 5cm x 5cm x 0,11cm, beschichtet mit Antihaftbeschichtungsmaterial) von Hand mit der beschichteten Seite auf den mit Nanowires bedeckten PDMS-Stempel aufgedrückt.

Das Probenpaket (unbeschichtetes Glassubstrat→ PDMS-Stempel→ Beschichtetes Glassubstrat) wird umgedreht und auf einer Heizplatte beschwert mit einer Metallplatte (Gewicht 800g) bei 50°C getrocknet. Nach 1h wird das Probenpaket von der Heizplatte genommen und auf dem Labortisch abkühlen gelassen. Sobald die Probe abgekühlt ist wird zuerst die Metallplatte entfernt, mit einer Hand stabilisiert man das beschichtete Substrat und mit der anderen entfernt man durch abziehen den PDMS-Stempel und das unbeschichtete Glassubstrat.

### II.4.D. Charakterisierung

### 1. Transmissionsmessung:

Die Transmission wurde mit Hilfe eines Spektrometers (Gerät: Ocean Optics QEPro, Lampe: DH-2000-BAL) ermittelt.

### 2. Leitfähigkeitsbestimmung:

Die Leitfähigkeit wurde mit Hilfe einer 2-Punkt Messung (Firma: Keithley, Gerät: 2000 Multimeter) ermittelt auf einer jeweiligen Fläche von 5mm x 5mm, welche auf zwei gegenüberliegenden Seiten mit Silberleitlack kontaktiert wurden.

### II.5. Nanoimprint 2

Im Folgenden wird die Herstellung (Variante 2) einer Gitterstruktur aus Silber-Nanowires mit Hilfe eines PDMS-Stempels beschrieben, in der sich die Silber-Nanowires in den quadratischen Gitterflächen anordnen und diese Flächen jeweils voneinander durch gitterförmig, angeordnete Linien getrennt sind:

### II.5.A. Vorbehandlung des antihaftbeschichteten Substrates

Auf ein Glassubstrat (Größe 10cm x 10cm x 0,11cm), beschichtet mit dem Antihaftbeschichtungs-material (siehe Punkt 2) wird ein PDMS- Stempel mit Gitterstruktur (Herstellung beschrieben unter Punkt 1) aufgelegt. Dann wird das Substrat inklusive aufgelegten Stempel einer Plasmabehandlung in einer Plasmakammer unterzogen (Dauer: 30min, Gas: Sauerstoff). Der PDMS- Stempel wird nur aufgelegt und nicht angedrückt, um so die quadratischen Flächen der Gitterstruktur des Stempels zu hydrophilisieren.

Und auch das eigentlich hydrophobe, beschichtete Substrat ist nach der Plasmabehandlung hydrophil.

### II.5.B. Beschreibung der Aufbereitung der Silber-Nanowirelösung kurz vor Probenherstellung

Das Probengefäß mit der darin befindlichen Nanowire-Lösung wird mit Hilfe eines Vortexer (Firma Heidolph, Typ Reax control, Speed 2500rpm)kurz vor der Probenherstellung aufgeschüttelt um den Bodensatz wieder zu dispergieren.

### II.5.C. Beschichtungsvorgang

Das hydrophiliserte Substrat wird plan auf einen Labortisch aufgelegt. Es wird mittig ein Tropfen (Volumen 20µl) der aufbereiteten Nanowire- Lösung aufgetragen und der hydrophilisierte PDMS- Stempel wird so von Hand aufgedrückt, dass sich die Lösung gleichmäßig unter dem Stempel verteilt und überschüssiges Material verdrängt wird. Um das überschüssige Lösungsmittel abzudampfen wird die Probe (Substrat + Stempel) auf eine Heizplatte gelegt und auf 50°C erwärmt. Während dieses Prozesses wird auf den PDMS-Stempel eine Metallplatte (Gewicht 800g) aufgelegt. Nach 15min wird das Probenpaket (Substrat→ Stempel → Metallplatte) von der Heizplatte genommen und auf dem Labortisch abkühlen gelassen. Sobald die Probe abgekühlt ist, wird zuerst die Metallplatte entfernt, mit einer Hand stabilisiert man das Substrat auf der Tischplatte und mit der anderen entfernt man durch abziehen den PDMS-Stempel.

### Zitierte Literatur

H. Feng, Y. Yang, Y. You, G. Li, J. Guo, T. Yu, Z. Shen, T. Wu, B. Xing, Chem. Commun. 2009, 1984.
J. H. M. Maurer, L. González-García, B. Reiser, I. Kanelidis, T. Kraus, ACS Appl. Mater. Interfaces 2015, 7, 7838.

## Patentansprüche

1. Verfahren zur Herstellung von metallischen Strukturen aus Bündeln von Nanodrähten umfassend die folgenden Schritte:
(a) Bereitstellung einer Zusammensetzung umfassend metallische Nanodrähte und mindestens ein Lösungsmittel;
(b) Strukturierung der Zusammensetzung auf einem Substrat durch Kontaktieren einer Strukturvorlage mit der Zusammensetzung vor oder nach der Kontaktierung der Zusammensetzung mit dem Substrat;
(c) Mindestens teilweise Entfernung des Lösungsmittels mit auf das Substrat aufgebrachter Strukturvorlage unter der Ausbildung von Bündeln parallel ausgerichteter Nanodrähte auf der Oberfläche.

2. Verfahren nach Anspruch 1, **dadurch gekennzeichnet, dass**
das Auftragen und die Strukturierung durch Auftragen der Zusammensetzung auf einem Substrat und nachfolgendes Aufbringen einer Strukturvorlage auf das Substrat unter teilweiser Verdrängung der Zusammensetzung erfolgt.

3. Verfahren nach Anspruch 1 oder 2, **dadurch gekennzeichnet, dass**
das Auftragen und die Strukturierung durch Auftragen der Zusammensetzung in eine strukturierte Maske erfolgt.

4. Verfahren nach einem der Ansprüche 1 bis 3, **dadurch gekennzeichnet, dass**
mindestens 50 Gew.-% der Nanodrähte eine Länge von über 1 µm aufweisen.

5. Verfahren nach einem der Ansprüche 1 bis 4, **dadurch gekennzeichnet, dass** von den Nanodrähten mindestens 50 Gew.-% ein
Aspektverhältnis von Länge zu Durchmesser von mindestens 500:1 aufweisen.

6. Verfahren nach einem der Ansprüche 1 bis 5, **dadurch gekennzeichnet, dass**
die Nanodrähte einen mittleren Durchmesser von unter 15 nm aufweisen.

7. Verfahren nach einem der Ansprüche 1 bis 6, **dadurch gekennzeichnet, dass**
die Nanodrähte einen mittleren Durchmesser von unter 5 nm aufweisen.

8. Verfahren nach einem der vorhergehenden Ansprüche, **dadurch gekennzeichnet, dass**
die erhaltenen Strukturen in einem weiteren Schritt thermisch oder mit Plasma behandelt werden.

9. Verfahren nach einem der vorhergehenden Ansprüche, **dadurch gekennzeichnet, dass**
die Strukturvorlage ein Stempel ist.

10. Verfahren nach Anspruch 9, **dadurch gekennzeichnet, dass**
die Bündel parallel zur Oberfläche liegen und in Längsrichtung Vertiefungen der Strukturvorlage folgen.

11. Beschichtetes Substrat erhalten durch das Verfahren nach einem der Ansprüche 1 bis 10.

12. Beschichtetes Substrat nach Anspruch 11, **dadurch gekennzeichnet, dass**
das beschichtete Substrat und die metallischen Strukturen mindestens teilweise transparent erscheinen.

13. Verwendung eines Substrats nach einem der Ansprüche 11 oder 12 als Leiterbahn in elektronischen Anwendungen, in Touch-Screen-Displays, in Solarkollektoren, in Displays, als RFID-Antenne, oder in Transistoren.

## Claims

1. A process for producing metallic structures from bundles of nanowires, comprising the following steps:
(a) providing a composition comprising metallic nanowires and at least one solvent;
(b) structuring the composition on a substrate by contacting a structure template with the composition before or after the contacting of the composition with a surface;
(c) at least partly removing the solvent while the structure template is in contact with the surface under formation of bundels of parallel aligned nanowires on the surface.

2. The process as claimed in claim 1, **characterized in that**
the applying and the structuring are effected by applying the composition to a substrate and subsequently applying a structure template to the substrate with partial displacement of the composition.

3. The process as claimed in claim 1 or 2, **characterized in that**
the applying and the structuring are effected by applying the composition into a structured mask.

4. The process as claimed in any of claims 1 to 3, **characterized in that**
at least 50% by weight of the nanowires have a length exceeding 1 µm.

5. The process as claimed in any of claims 1 to 4, **characterized in that**
at least 50% of the nanowires have an aspect ratio of length to diameter of at least 500:1.

6. The process as claimed in any of claims 1 to 5, **characterized in that**
the nanowires have a mean diameter below 15 nm.

7. The process as claimed in any of claims 1 to 6, **characterized in that**
the nanowires have a mean diameter below 5 nm.

8. The process as claimed in any of the preceding claims, **characterized in that**
the structures obtained are subjected to thermal treatment or plasma treatment in a further step.

9. The process as claimed in any of the preceding claims, **characterized in that**
The structure template is a stamp.

10. The process according to claim 9, **characterized in that**
the bundles are parallel to the surface and follow the recesses of the structure template in longitudinal direction.

11. A coated substrate obtained by the process as claimed in any of claims 1 to 10.

12. The coated substrate as claimed in claim 11, **characterized in that**
the coated substrate and the metallic structures have an at least partly transparent appearance.

13. The use of a substrate as claimed in either of claims 11 and 12 as a conductor track in electronic applications, in touchscreen displays, in solar collectors, in displays, as an RFID antenna, or in transistors.

## Revendications

1. Procédé de fabrication de structures métalliques composées de faisceaux de nanofils, comprenant les étapes suivantes consistant à :
(a) fournir une composition comprenant des nanofils métalliques et au moins un solvant ;
(b) structurer la composition sur un substrat par la mise en contact d'un modèle de structure avec la composition avant ou après la mise en contact de la composition avec le substrat ;
(c) éliminer au moins en partie le solvant avec le modèle de structure appliqué au substrat en réalisant des faisceaux de nanofils alignés en parallèle sur la surface.

2. Procédé selon la revendication 1, **caractérisé en ce que** l'application et la structuration sont effectuées en appliquant la composition sur un substrat et en appliquant ensuite un modèle de structure sur le substrat en repoussant partiellement la composition.

3. Procédé selon la revendication 1 ou 2, **caractérisé en ce que** l'application et la structuration sont effectuées en appliquant la composition dans un masque structuré.

4. Procédé selon l'une quelconque des revendications 1 à 3, **caractérisé en ce qu'**au moins 50 % en poids des nanofils présentent une longueur supérieure à 1 µm.

5. Procédé selon l'une quelconque des revendications 1 à 4, **caractérisé en ce que** parmi les nanofils, au moins 50 % en poids présentent un rapport d'aspect entre longueur et diamètre d'au moins 500:1.

6. Procédé selon l'une quelconque des revendications 1 à 5, **caractérisé en ce que** les nanofils présentent un diamètre moyen inférieur à 15 nm.

7. Procédé selon l'une quelconque des revendications 1 à 6, **caractérisé en ce que** les nanofils présentent un diamètre moyen inférieur à 5 nm.

8. Procédé selon l'une quelconque des revendications précédentes, **caractérisé en ce que** les structures obtenues sont soumise à un traitement thermique ou au plasma dans une étape supplémentaire.

9. Procédé selon l'une quelconque des revendications précédentes, **caractérisé en ce que** le modèle de structure est une matrice.

10. Procédé selon la revendication 9, **caractérisé en ce que** les faisceaux se trouvent en parallèle à la surface et suivent dans la direction longitudinale des creux du modèle de structure.

11. Substrat revêtu, obtenu par le procédé selon l'une quelconque des revendications 1 à 10.

12. Substrat revêtu selon la revendication 11, **caractérisé en ce que** le substrat revêtu et les structures métalliques ont un aspect au moins partiellement transparent.

13. Utilisation d'un substrat selon l'une quelconque des revendications 11 ou 12 comme une piste conductive dans des applications électroniques, dans des écrans tactiles, dans des capteurs solaires, dans des dispositifs d'affichage, comme antenne RFID ou dans des transistors.
